(19) Europäisches Patentamt / European Patent Office / Office européen des brevets

(11) **EP 3 364 296 B1**

(12) **EUROPEAN PATENT SPECIFICATION**

(45) Date of publication and mention
of the grant of the patent:
**06.07.2022 Bulletin 2022/27**

(21) Application number: **17156947.8**

(22) Date of filing: **20.02.2017**

(51) International Patent Classification (IPC):
*G06F 9/455* (2018.01)  *G06F 30/20* (2020.01)
*G06F 9/48* (2006.01)  *G06F 9/50* (2006.01)

(52) Cooperative Patent Classification (CPC):
**G06F 9/455; G06F 9/4843; G06F 9/485;
G06F 9/4887; G06F 9/5027; G06F 9/5038;
G06F 30/20**

(54) **SIMULATING EXECUTION-TIME VARIATIONS AND SCHEDULING IN A BLOCK-ORIENTED SIMULATION SYSTEM**

SIMULATIONSAUSFÜHRUNGSZEITABWEICHUNGEN UND PLANUNG IN EINEM BLOCKORIENTIERTEN SIMULATIONSSYSTEM

SIMULATION DES VARIATIONS DE TEMPS D'EXÉCUTION ET PROGRAMMATION DANS UN SYSTÈME DE SIMULATION ORGANISÉ EN BLOCS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**22.08.2018 Bulletin 2018/34**

(73) Proprietor: **Naderlinger, Andreas
5023 Salzburg (AT)**

(72) Inventor: **Naderlinger, Andreas
5023 Salzburg (AT)**

(56) References cited:
**EP-A1- 2 275 931      US-A1- 2002 166 110
US-B1- 6 952 825**

• **THOMAS A HENZINGER ET AL: "The embedded machine", PROCEEDINGS OF THE ACM SIGPLAN 2002 CONFERENCE ON PROGRAMMING LANGUAGE DESIGN AND IMPLEMENTATION (PLDI'02) : BERLIN, GERMANY, JUNE 17-19, 2002; [ACM SIGPLAN NOTICES ; 37.2002,5], NEW YORK, NY : ASSOCIATION FOR COMPUTING MACHINERY, US, 17 May 2002 (2002-05-17), pages 315-326, XP058206655, DOI: 10.1145/512529.512567 ISBN: 978-1-58113-463-6**

## Description

## TECHNICAL FIELD

The present disclosure relates to the field of the simulation of real-time systems, which software-tasks executed by one or more hardware-nodes has to comply with real-time constraints.

## BACKGROUND

Model-based development is a well-established design approach when developing software-intensive systems as found, for example, in the automotive or aerospace sector. In this area, *MathWorks MATLAB/Simulink*® is the de-facto industrial standard for modeling and simulation of real-time control applications, in which the target hardware providing the control function(s) to be simulated usually is an application specific embedded system. It is based on the synchronous block diagram (SBD) formalism that shows strong advantages over source code in terms of, for example, user (e.g. a control engineer) acceptance and rapid prototyping capabilities. Additionally, the affinity to the synchronous reactive (SR) paradigm of computation renders SBDs particularly suitable for formal validation. MATLAB/Simulink is a block oriented simulation tool, which has become a de-facto industry standard. However, the principles of block-oriented simulation are well known and also used by various other software tools in a similar manner as MATLAB/Simulink does. The publication EP 2275931 A1 describes a method for simulating software components using block-oriented simulation engines such as MATLAB/Simulink that use a static block update order. For simulating the execution time, a task is split into a task release block, a task execution block, a task termination block, and a delay block, which is arranged between the task release block and the task termination block. Due to the delay block algebraic loops are avoided and a static block update order can always be found before starting the actual simulation. A general discussion concerning block-oriented simulation systems is given, for example, in *B.P.* Zeigler et. al, "Theory of Modeling and Simulation: Integrating Discrete Event and Continuous Complex Dynamic System", Elsevier Science Publishing, 2nd ed., January 2000 (e.g. section 3.3.5, Continuous System Simulation Languages and Systems also referring to MATLAB/Simulink). The publication US 6,952,825 B1 describes a concurrent timed digital system design method and environment for simulating software components. The execution times are simulated with the help of delay functions and a scheduler. Therefore, this approach is not suitable for block-oriented simulation engines such as MATLAB/Simulink that use a static block update order. Related prior art is described in the publication US 2002/0166110 A1 as well as in Henzinger, Kirsch, "The Embedded Machine: Predictable, Portable Real Time Code", in: Proc. of the International Conference on Programming Language Design and Implementation (PLDI), ACM Press, 2002, pp. 315-3267.

The key assumption of the underlying programming model is that computation happens in zero time and that outputs are provided in reaction to inputs either instantly (zero execution time abstraction), i.e. without any observable delay, or with a fixed delay that is identical for every invocation of a task. This approach matches well with known control engineering approaches, in which sampling jitter is often neglected and constant latencies (dead-times) are assumed between reading inputs and writing outputs. In addition, software structures available for modeling control systems match well with established concepts and components in a control engineer's tool kit. Assuming that plant dynamics (i.e. the dynamics of the physical system to be controlled) have been modeled sufficiently, a model in the loop (MIL) simulation allows to assess performance and stability characteristics of the control loop.

Ultimately a code generator turns all the blocks used to implement a control law into code (typically C code and finally executable code) to be executed on a hardware platform. Any hardware platform usually exhibits all the imperfections (e.g. execution time jitter, latencies, etc.) that were neglected in the abstract model used to design the control loop. On the real hardware platform jitter caused by, for example, execution time variations or start-time delays may have considerable influence on the system behavior and may compromise its stability.

Variations in execution time may be caused in different signal paths through the control system. Those variations can be significant, since controllers typically operate in one of several modes according to some global system condition and change functionality, e.g. to compensate increased system loads at higher engine speed. Such effects are neglected to a large extent in models with pure SR semantics. In addition, the individual functionalities of a controller, which may have been designed and tested independently, should not be regarded in isolation on a platform. Practically infinite computational resources (as assumed in simulation) meet limited capacity of the CPU of a specific hardware platform which has to handle a number of competing tasks.

The task concept itself is another semantic break between the initial SBD model and the final software system. In order to achieve a reasonable CPU utilization, multirate models may be executed as multitask implementations. Only at the time of system integration, a system engineer decides on the mapping between controller functionalities and tasks and, more recently, also to cores. Further decisions involve task priorities and execution orders within the same task. At run time a real-time operating system then schedules the individual tasks according to some policy that has to satisfy the overall timing requirements of the system. Especially preemptive multi-tasking approaches further increase non-determinism already caused by varying system load and execution times and may lead to serious data integrity problems. Cost-intensive hardware in the loop (HIL) simulations are required to be able to assess the real system behavior.

## SUMMARY

A method for simulation of a real-time system on a workstation is described herein. In accordance with one embodiment, the realtime system includes target hardware and at least one task executed by the target hardware, and the method includes using a block-oriented simulation system for simulating a model of the real-time system, wherein the model is represented by a block diagram composed of at least one block that represents the at least one task. For the purpose of simulation, each task is implemented by a task function composed of a sequence of one or more code segments, wherein an execution time concerning execution by the target hardware is associated with each code segment. Further, the simulation system includes a simulation engine that controls the execution of each task, wherein each task function is executed in a separate task thread, and when the execution of the task function reaches the end of a code segment, a current simulation time provided by the simulation engine is compared with a desired execution time. Execution of the task thread is suspended, when the current simulation time has not reached the desired execution time, wherein the desired execution time is determined based on the execution times associated with the one or more code segments.

Furthermore, a system for simulating a real-time system comprising target hardware and at least one task executed by the target hardware is described herein. In accordance with one example, the system includes a workstation with at least one processor executing an operating system (OS) and a block-oriented simulation system for simulating a model of the real-time system. The simulation model is represented by a block diagram composed of at least one block that represents at least one task. For the purpose of simulation, each task is implemented by a task function composed of a sequence of one or more code segments, wherein an execution time concerning execution by the target hardware is associated with each code segment. The simulation system includes a simulation engine that controls the execution of each task. Thereby, each task function is executed in a separate task thread, and when the execution of the task function reaches the end of a code segment, a current simulation time provided by the simulation engine is compared with a desired execution time. Execution of the task thread is suspended, when the current simulation time has not reached the desired execution time. The desired execution time being determined based on the execution times associated with the one or more code segments.

The invention is defined by the appended set of claims.

## BRIEF DESCRIPTION OF THE DRAWINGS

The invention can be better understood with reference to the following drawings and descriptions. The components in the figures are not necessarily to scale; instead emphasis is placed upon illustrating the principles of the invention. More-over, in the figures, like reference numerals designate corresponding parts. In the drawings:

Figure 1 illustrates different callback methods of an S-Function used to implement a user-defined block in a MATLAB/Simulink model.
Figure 2 illustrates a simple model represented by a block-diagram with two blocks, which may be implemented using S-Functions.
Figure 3 is a schematic diagram illustrating how the Simulink simulation engine calls the callback methods *mdlOutputs* and *mdlUpdate* for all blocks of a block-diagram, which are implemented using S-Functions.
Figure 4 is a schematic diagram illustrating how the Simulink simulation engine may use the callback methods *mdlOutputs* and *mdlUpdate* as an interface to a task thread associated with a specific xTask block of a block diagram; the task thread includes a task function that implements the desired function of the xTask block.
Figure 5 is a schematic diagram illustrating the segmentation of a code sequence into different code segments, wherein each segment is associated with a defined execution time, which is provided as a parameter to a delay/synchronization instruction.
Figure 6 is a schematic diagram illustrating the synchronization mechanism between the (Simulink) simulation engine and a task thread associated with an xTask block, which is a direct feed-through (DF) block.
Figure 7 is a code listing illustrating the synchronization mechanism between the (Simulink) simulation engine and a task thread associated with an xTask block, which is a non-direct feed-through (NDF) block.
Figure 8 is a schematic diagram illustrating a task state model of the task thread associated with an xTask block.

## DETAILED DESCRIPTION

Herein, an approach is presented that brings software-related aspects into the model based approach of a synchronous block diagram (SBD). Thereby aspects are taken into account which go beyond the scope of typical software in the loop (SIL) simulations, such as software execution times and preemption effects. In typical SIL simulations, execution times are usually represented as constant delays (dead times). For example, *Mathworks MATLAB/Simulink* provides dedicated delay blocks to delay the propagation of signals. This is a widely used mechanism to mimic the execution time of a control algorithm on an actual hardware platform in the simulation. It is considered that a simulation would benefit from a more fine-grained modelling of execution time so as to better reflect reality.

In the work presented herein, *MATLAB/Simulink* was used as simulation tool, which allows the integration of code provided by the user (as so-called *S-Functions)* into the block diagram. It is noted, however, that other block-oriented simulation tools are available and the embodiments described herein in connection with *Simulink* may readily be used in connection with other block-oriented simulation tools (e.g. *Scilab/XCos)*. However, *MATLAB/Simulink* is regarded as a de-facto standard in the field of automation and control. Therefore, details concerning the *MATLAB/Simulink* simulation environment is not further explained in detail herein and reference is made to the official Simulink Reference (e.g. *The MathWorks, Inc., Simulink Reference R2016b),* available online *http://mathworks.com/help/simulink/.*

In the following a new block type is presented that is referred to as "xTask block" (eXecution time considering Task block). It may be implemented as a Simulink S-Function block, but behaves differently (from a "normal" S-Function) in several aspects as discussed below. Firstly, the execution does not follow the normal zero execution time abstraction, but rather lasts for a finite amount of simulation time and also may continue for several simulation time steps. It is thereby assumed that the execution time information for the individual controllers and for certain hardware platform are available (e.g. by measurement and statistical analysis).

An xTask block may represent the concept of an OS (operating system) task to which a priority is assigned. According to the embodiments described herein, the progress of time is simulated during simulation; the simulated time, which the individual blocks of a model "see", is referred to as "simulation time". In one specific implementation, preemptive multitasking may additionally be considered in the simulation. That is, within one Simulink model all xTask blocks may be scheduled such that their execution "consumes" simulation time and only one task can be executed at one time. In order to take preemption effects into account, simulation time must progress during the (simulated) execution of a block, not only after the execution of a block. This stands in stark contrast to the regular SR approach usually used by *Simulink.* The presented static-priority scheduling is based on a synchronization mechanism between blocks that ensures a correct timing behavior.

A development process that uses the herein-presented approach may start with a time-invariant and platform-independent model and evolve to a platform-dependent one. Eventually it allows simulation results being closer to the real system behavior on a hardware platform, as it already considers aspects that go beyond pure control engineering concepts. However, before explaining the above-mentioned xTask block in more detail, some aspects of the simulation tool *Simulink* are summarized. As mentioned, however, the explanations below are also applicable for other block-oriented simulation tools.

Simulink is a modeling and simulation environment for dynamic systems that may include one or more blocks, which represent a time-continuous model of the physical plant, coupled with discrete blocks that represent the controller functionality. The interaction between the blocks may be represented by a block diagram that represents a model of the overall system (plant(s) and controller(s)). The system dynamics are implemented as blocks connected by signals between output and input ports. Each block receives (at input ports) input signals and has a state, and the output signals (provided at output ports) of a block are calculated based on the state or based on the input and the state. An input port of a block may either be a direct-feedthrough (DF) input port or a non-direct-feedthrough (NDF) input port. While signals applied at DF input ports directly affect the output of the block at the same time instant (Mealy-type), signals applied at NDF input ports only affect the block's state (Moore-type). In the following, blocks with one or more DF input ports are referred to as a DF blocks and blocks with only NDF input ports are referred to as NDF blocks.

The simulation is controlled by a part of the simulation software referred to as simulation engine or simulation thread. During the simulation loop, the simulation engine repeatedly updates the state of the model (the blocks) by computing the system inputs, outputs, and states in the progress of time at consecutive steps determined by a so-called solver. At each step, the block-diagram can be viewed as an SR model. During simulation, the execution of the model (controlled and accomplished by the mentioned solver) requires the execution of the individual blocks in a particular order that may be determined during an initialization step of the simulation. This so-called "block sorted order" is determined based on data dependencies and feedthrough characteristics of the blocks in the block-diagram. In this regard, two basic rules apply: (i) a block has to be executed before any of the blocks whose direct-feedthrough input port(s) it drives and (ii) non-direct feedthrough blocks can execute in arbitrary order as long as they precede any block whose direct-feedthrough inputs they drive. Additionally, without violating the two rules above, block priorities, which may be assigned to individual blocks, may influence the sorted order.

To avoid non-deterministic behavior due to causality problems of feedback loops (algebraic loops), Simulink requires the blocks to be executed in a particular simulation step to form a directed acyclic graph (DAG). It is important to note that this does not necessarily entail that the network (blocks connected by signals) itself to be a DAG. Only the algebraic loops (if any) during execution need to be broken. This is the case, if every loop in the block diagram includes at least one NDF block.

The S-Function functionality enables the extension of Simulink by custom blocks implemented, for example, in the programming language C. An S-function appears as a block in a block diagram and is implemented as a set of callback functions that the simulation engine executes at different stages during the simulation. Repeatedly during the simulation loop, firstly, the output function *mdlOutputs* calculates and sets the block's output signal values/output variables (see, e.g. *http://mathworks.com/help/simulink/sfg/mdloutputs.html*) and, secondly, the update function *mdlUpdate* calculates and sets the block's state variables (see *http://mathworks.com/help/simulink/sfg/mdlupdate.html*). This so-called function separation requirement of Simulink entails that NDF blocks cannot directly access their inputs in the output function.

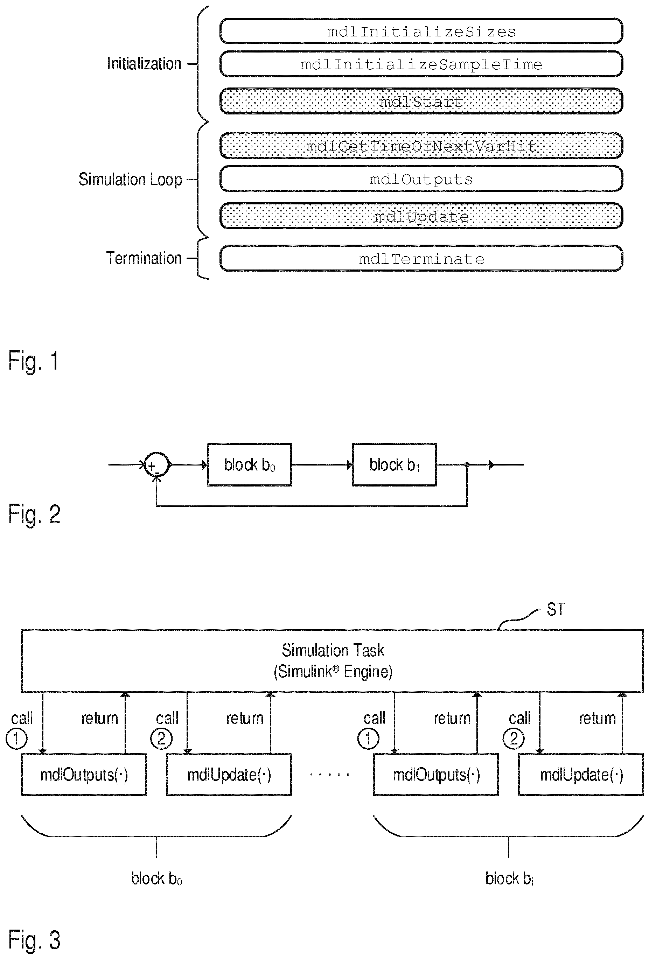

Figure 1 illustrates the main interaction points of the simulation engine with the S-function API (application programming interface) for blocks with non-continuous state during a simulation run. Functions that are grayed out are optional and depend on the specific settings of a block. It is noted that the simulation thread ST (i.e. the Simulink Engine, which includes the mentioned solver) invokes a particular kind of function (e.g. *mdlOutputs*) for all the blocks in a model before invoking the next one. So, the states of the blocks in a model (block diagram) are not updated before all outputs of the blocks have been set. Figure 2 illustrates a simple model with two blocks $b_0$ and $b_1$, wherein block $b_0$ may represent a controller and block $b_1$ a plant to be controlled. The output signal of block $b_0$ is supplied as input signal to block $b_1$ (i.e. the output of block $b_0$ drives block $b_1$). The signal source providing the input signal for block $b_0$ has been omitted to keep the illustration simple. If the blocks $b_0$ and $b_1$ are user specific the user must implement the functionality of the blocks using Simulink's S-function API (i.e. the mentioned output function and update function *mdlOutputs* and *mdlUpdate*, respectively).

Figure 3 illustrates how the simulation thread ST calls the functions *mdlOutputs* and *mdlUpdate* for all S-function blocks $b_i$ (i=0, ..., N-1). The block index *i* represents the sorted order of the blocks $b_i$. First (and after initialization), the *mdlOutputs* functions of all blocks $b_i$ are called in accordance with the block order. Thereby, the simulation thread ST makes the current simulation time (and the current state variables of the blocks) available to the *mdlOutputs* functions. For each block $b_i$ the *mdlOutputs* function calculates the corresponding block output signal values and makes those available to the simulation thread ST. Second, the *mdlUpdate* functions of all blocks $b_i$ are called in accordance with block order. The simulation thread ST makes the current simulation time (and the block input signal values) available to the *mdlUpdate* functions. For each block $b_i$ the *mdlUpdate* function calculates updated block state variables and makes those available to the simulation thread ST.

One can see from Fig. 3 that the calculations made by the output and update functions *mdlOutputs* and *mdlUpdate* consume effectively no simulation time. In each simulation step the simulation thread ST passes the simulation time (i.e. a time instant) as parameter to the output and update functions *mdlOutputs* and *mdlUpdate*, and these functions can only use this single time instant to perform the required calculations. Thus, simulation times only proceeds between the simulation steps, which is referred to as zero execution time (ZET) abstraction as already mentioned above. This ZET abstraction is inherent in simulation environments such as Simulink or the like.

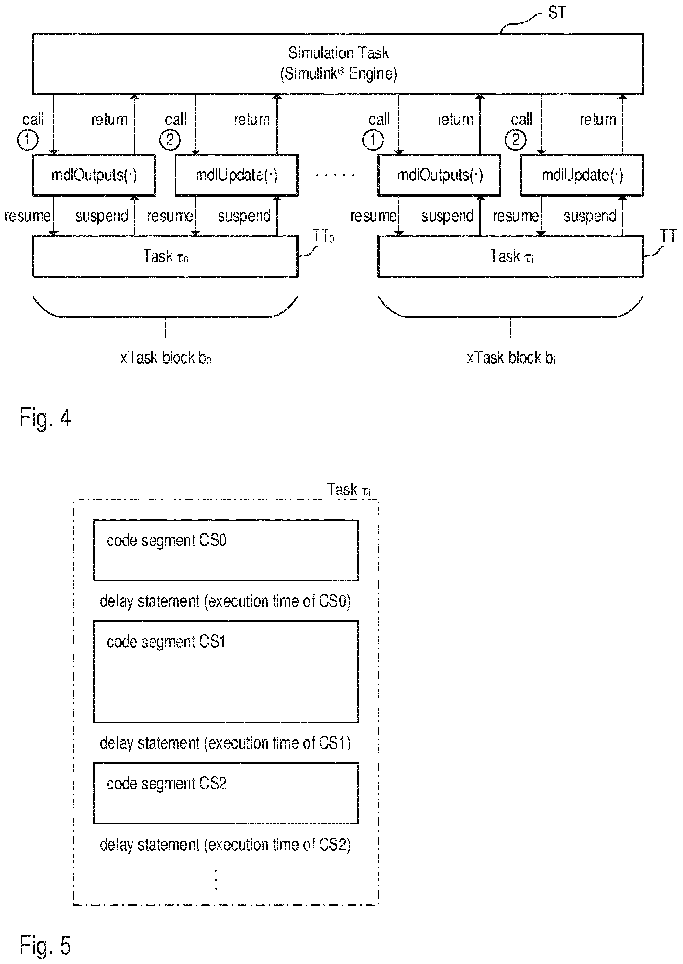

The concept of xTask blocks described herein overcomes the limitations of ZET abstraction. Therefore the structure shown in Fig. 3 is enhanced as illustrated in Fig. 4. Every xTask block $b_i$ within a model represents a time-triggered task $\tau_i$, which may be regarded as an OS task of the OS (operating system) of the target system. On the workstation that executes the simulation environment each task $\tau_i$ may be executed as a separate thread (task thread $TT_i$), while the so-called simulation engine (e.g. Simulink Engine) may also be a separate thread referred to as simulation thread ST. In one example, the simulation thread and all the task threads are executed within the same process on the workstation. It is noted that a process refers to an abstraction of a running program (e.g. MATLAB) and has an inherent single thread of control and an associated address space (a list of memory locations, which the process can read and write). A process may start and contain further threads of control (threads) running in quasi-parallel. A thread is more lightweight concept and allows multiple executions to take place in the same process environment. An important aspect hereby is that all the threads of a process share the same address space. Thus the simulation engine (including the representation of the plant) and the task threads (the representation of the controllers) have access to the same memory locations. No inter-process communication (IPC), for example via message passing or sockets, is required for the plant to interact with the controllers as it is the case for many co-simulation environments that use different processes for simulating the plant (e.g. in MATLAB/Simulink) and the controllers.

Every input *u* received by the task and every output *y* generated by the task is modeled as an individual block input and output signal, respectively. The execution of every task $\tau_i$ is determined by a task period $\pi_i$ and an offset (phase) $\phi_i$. That is, the task $\tau_i$ is executed in every $\pi_i$-th cycle starting at the $\phi_i$-th cycle. It may be assumed that an internal synchronization between tasks does not take place. Further, it may be assumed that the task set is schedulable in such a manner, that a task is only activated once per cycle and its priority is fixed and unique. A task that complies with this assumption is referred to OSEK basic conformance class 1 (BCC1). Tasks may not be independent, i.e. there may exist precedence relations and/or data dependencies. The k-th job (initiation) of a task $\tau_i$, denoted as $\tau_i(k)$ corresponds to the k-th ac-

tivation of xTask block $b_i$ that is denoted as $b_i(k)$. The time instant of the activation is denoted as $t_i^a(k)$. The characteristics of xTask blocks are in stark contrast with the characteristics of conventional blocks of a block-oriented simulation environment and can be summarized as follows:

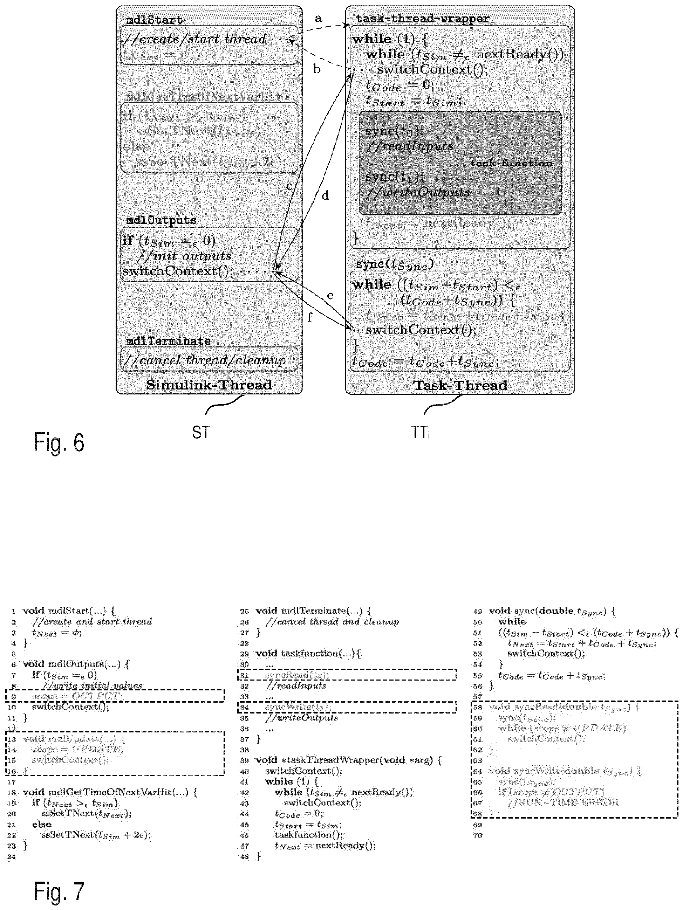

(i) *Non-synchronous execution* - Generally, the simulated model is represented by a block diagram, which is composed of at least one xTask block $b_i$ that represents a task $\tau_i$ (e.g. a controller operating in accordance with a desired control law). The specific task $\tau_i$ is implemented by a task function composed of a sequence of one or more code segments, wherein an execution time is associated with each code segment (by means of code instrumentation, see also Fig. 5). Any simulation system such as Simulink includes a simulation engine (simulation thread, which may be executed in a separate thread) that controls the execution of the xTask block $b_i$ (and thus the task $\tau_i$). Thereby, the task function of each task $\tau_i$ is executed in a single separate thread (see, e.g. Fig. 6, task thread $TT_i$), whose execution is synchronized with the simulation engine only at specific time instants. For block activation $b_i(k)$, the start time $t_i^s(k)$ of the execution and the end time $t_i^e(k)$ of the execution do not coincide. As a consequence, the execution of a block lasts for a finite execution time $T_i^x(k) > 0$, such that $t_i^e(k) = t_i^s(k) + T_i^x(k)$ and $t_i^e(k) \leq t_i^s(k+1)$ (the preemptive case is discussed later). In this regard, it is noted that the execution times of the individual activations of block $b_i(k)$ may vary just like the execution time of the individual jobs of a real-time task typically vary. This may be due to different input data, states of the task (resulting in different code paths taken) and the entire system (hardware and software) including caches. As a consequence, the observable output of the task - i.e. the output(s) of a block in the present discussion - may be subject to jitter. In contrast to the above, $t_i^e(k)$ equals $t_i^s(k)$ (i.e. $T_i^x(k) = 0$) when using the known standard approaches of block-oriented simulation. As mentioned, the execution of the task thread of a task is synchronized with the execution of the simulation engine only at specific time instants, at which the data flow between simulation engine and task thread (i.e. the handover of input and output signal values of an xTask block) is coordinated by the synchronization mechanism described herein.

(ii) Arbitrary I/O instants - By separating $t_i^s(k)$ and $t_i^e(k)$ (different from the ZET abstraction), also the time instants for reading inputs and providing outputs are affected. Intuitively, one might think that every input $u$ is read at $t_i^s(k)$, while every output $y$ is provided at $t_i^e(k)$. However, this appears to be an unnecessary restriction. Input- and output operations may be desirable also during execution of the task $\tau_i$ and are therefore allowed at any time during $T_i^x(k)$ (with minor restrictions for xTasks implemented as NDF block as explained below). This leads to a fine grained interaction with other blocks, where plant and controllers are always up-to-date.

(iii) *Explicit precedency/priority* - As SR models are causal, a data (input/output) relation between two DF blocks implies a precedence constraint such that - although if their activation coincide at the same simulation time - the block that generates an output must be activated before the block that receives the output as input. With xTasks, precedence constraints and data dependencies become two orthogonal aspects. Therefore, to support a realistic simulation of a set of tasks that are not independent (i.e. there may exist precedence relations and/or task data dependencies), the feedthrough of xTask blocks are non-direct (NDF) in the general case. This avoids causality issues and makes the block dependencies a DAG. Each xTask block $b_i$ has a unique priority $i \geq 0$ that corresponds to the priority of the task $\tau_i$. Explicit block priorities are reflected in the execution order and facilitate systems with tasks of different levels of criticality.

(iv) *Scheduling* - The execution of an xTask block $b_i(k)$ may start after its activation $(t_i^s(k) \geq t_i^a(k))$, for example, if the execution of another xTask block $b_j$ with higher priority prevents the execution of block $b_i$ from being started. This corresponds to a situation, in which multiple tasks are scheduled under limited resources, i.e. a situation, in which the tasks share a single CPU. This property implies that adding a highpriority xTask block to the model (or increasing the activation frequency of an existing block) influences the timing behavior of the other blocks and thus of the overall system (just as it would be the case on the real target hardware). The xTask concept described herein supports different scheduling strategies.

(v) *Preemption/Cooperation* - For improved responsiveness, operating systems may schedule tasks preemptively and hand control over to the task with the highest priority, as soon as such a task becomes ready. In the exemplary embodiments described herein, tasks $\tau_i$ may not be preempted at any time (at any assembly instruction) but at well-defined points only, which corresponds to a cooperative multitasking approach.

(vi) *Combined output/update function* - NDF blocks use an output function to write output signal values to output ports and an update function to read input signal values from input ports. Although this function separation is a requirement of Simulink (and other block oriented simulation tools), it significantly differs from the concept of using a single function with access to input and output signal values in arbitrary order in an ordinary task implementation. Only a single function (i.e. its task function) is associated with an xTask block (even if it is implemented as a NDF block). A synchronization mechanism, which is described further below, may be used to ensure that the execution of this function shows the correct timing with respect to its timing information included in the task function (e.g., by code instrumentation) and also observes Simulink's function separation requirement.

As outlined above, a proper modeling of software tasks that should exceed purely functional aspects may require a fine-grained consideration of execution times on the desired hardware platform. When executed on a host computer (for the purpose of simulation), the observed behavior of the code shall reflect the timing as if it was executed on the target platform. Annotation of the source code of the tasks functions is an efficient method to incorporate timing information in the xTask block. Accordingly, the source code of the task function of task $\tau_i$ is (e.g. automatically) annotated with a kind of dedicated delay function (also referred to as *sync* instruction), which may be called with a parameter that represents the execution time of a specific code segment of the source code of a task function. Those execution times might have been determined, for example, by profiling or static analysis. The mentioned automatic annotation of source code is also referred to as code instrumentation.

Once activated during simulation, the task $\tau_i$ associated with an xTask block is scheduled to execute its time annotated task function. The timing annotations segment the code of a task function into a finite number of contiguous segments, each having a specific execution time associated with the respective segment. Each segment includes a synchronization instruction. In the present example, each segment concludes with a synchronization instruction. That is, at segment boundaries, the task $\tau_i$ synchronizes with the simulation thread (e.g. Simulink engine) by calling the synchronization instruction and, consequently, with the plant or other xTask blocks in the model. Only when the actual simulation time has drawn level with the "desired" execution time given by the code annotation of a specific segment, the task $\tau_i$ executes the subsequent segment. In the examples described herein, the desired execution time may be provided as parameter to the mentioned synchronization instruction (see, e.g. *sync(·)* function calls shown in Fig. 6 ). For an accurate observation of I/O behavior, at least every read operation that is influenced by the global system state and every write operation that influences this state is preceded by a delay function call (i.e. the mentioned synchronization instruction), i.e. a code segment should always end directly before (or with) a read or write operation.

Let $\Sigma_i^k(s)$ be the sum of execution times that accumulate for the k-th job of task $\tau_i$ representing block $b_i$ until the execution of the source code statement s (i.e., the sum of the execution time parameters of all delay instructions being called by $b_i(k)$ until code statement s). The time when statement s is executed is denoted as t(s) and defined as follows:

$$t(s) = t_i^a(k) + \Sigma_i^k(s) + \Delta$$

, wherein $\Delta$ is the time span in the interval $[t_i^a(k), t(s)]$ , during which the task $\tau_i$ is not allowed to execute (e.g. due to preemption). The time span $\Delta$ may depend on the chosen scheduling scheme and the set of tasks with their execution times and priorities. In the fixed-priority preemptive setting discussed herein, for example, $\Delta = \Sigma_{0 \leq j < i} \delta_j$, wherein $\delta_j$ is the sum of the execution times of all jobs of higher priority tasks $\tau_j$ that execute within the interval $[t_i^a(k), t(s)]$ . In general, $\Delta$ might also include times that reflect context switch overhead, etc.

The above-described code annotation with delay statements (synchronization instructions), which represent the execution times on the target hardware platform is illustrated in Fig. 5. In the depicted example, the code is segmented in code segments CS0, CS1, CS2, etc. During the annotation a delay statement is inserted after each of the segments CS0, CS1, CS2, etc. Each delay statement is called with a parameter representing the execution time of the respective code segment. The code of a task may be segmented such that the segment boundaries are at the following points: an entry point of a task, an termination point of a task, an access to shared memory, an access to a register of the target hardware platform, a call to a function of the operating system or to a driver function provided by the target platform. However, different criteria for segmenting the code may be used.

As outlined above, our implementation of the xTask block is based on the S-Function block of Simulink and its respective API. Basically, an xTask block is an S-Function block with specific *mdlOutputs* and *mdlUpdate* functions (callback methods) that form an interface to a task function associated with the xTask block. In the following, a mechanism to execute a set of interacting controller tasks is described, wherein each controller task is represented by an xTask block inside a Simulink model. First, some general aspects of the synchronization mechanism between tasks $\tau_i$ with the simulation thread (Simulink engine, see Fig. 4) is described. This mechanism accounts for the requirements of both, Simulink itself (e.g. the function separation requirement) and the above-described xTask properties, such as non-synchronous execution, arbitrary I/O instants, or the combined output/update function for NDF blocks. Scheduling and the task state model to support preemption is described afterwards.

A time-annotated xTask task function runs in its own thread of execution that gets created and started during the simulation start-up phase. The delay statements that have been incorporated in the source code (see Fig. 5) allow synchronization between the task $\tau_i$ and the simulation thread ST (Simulink engine, see Fig. 4). They ensure that the individual code segments are not executed until the simulation time is in correspondence with the desired execution time given by the time annotation. Conceptually, the mechanism is based on a monitor (wait/signal) concept. During execution of a task thread $TT_i$, the simulation thread ST has to wait, until execution would exceed the current simulation time. While the task thread $TT_i$ waits, the simulation thread ST continues with the execution of other blocks, such as the plant or other xTask blocks, and eventually increases simulation time. At some subsequent simulation step, both the output and the update callback function (mdlOutputs and mdlUpdate) of the xTask block $b_i$ are candidates to signal the resumption of the task $\tau_i$. In the case where the xTask block is implemented as a NDF block, the synchronization mechanism restricts I/O access to the appropriate callback function (e.g. reading inputs is allowed in the mdlUpdate function only). It requires, however, that an output operation must not occur after an input operation at the same simulation time step. This can be ensured by the timing annotation in the task source code, for example. In the case where the xTask block is implemented as a DF block, only the output callback function is required.

In the following, the synchronization mechanism that allows progress of the simulation time while an xTask block is executed is described in more detail. In the examples described herein, the synchronization is based on POSIX threads (pthreads) as defined in IEEE Std. 1003.1c-1995 (Posix.lc, threads extensions). As an illustrative example, the execution of a single block is preempted and resumed in the next simulation step. Then it is shown how this mechanism can be adapted in order to allow for multiple blocks that have data dependencies.

As a first illustrative example only a case is considered, in which a single task $\tau_0$ is present in the system.

This task is represented by the xTask block $b_0$. For simplicity, we specify the task block to have a DF characteristic. This allows us to both read and write signals in the block's output function mdlOutputs and no update function mdlUpdate is required.

Figure 6 illustrates the synchronization mechanism between the task function (task thread TTo) of task $\tau_0$ and the simulation engine of Simulink (simulation thread ST). The simulation thread ST synchronously calls the S-Function callback functions mdlStart, mdlGetTimeOfNextVarHit, mdlOutputs, and mdlTerminate of the individual blocks (i.e. the callback functions for task $\tau_0$ in the present example). The interaction between the simulation engine and the S-Function API has been outlined above. The function mdlStart invoked in the initialization phase of the simulation creates and starts the thread TTo dedicated to the execution of task $\tau_0$ (see Fig. 6, arrow a). This task thread TTo may basically execute an endless loop, where each iteration corresponds to one job of the task. While the task is not yet ready (in the first iteration this means that the task's offset is still greater than the current simulation time $t_{Sim}$), the thread TTo is blocked (is suspended) and control is given back to the simulation engine (see Fig. 6, arrow b). It is assumed that the simulation time $t_{Sim}$ is always kept up-to-date by the simulation engine ST. The function switchContext (called by the task thread TTo) uses a wait/signal approach based on a condition-variable and is aware of the two threads. Upon each invocation the function switchContext suspends the current thread and resumes with the other one. Accordingly, the simulation thread ST then resumes with the execution of the simulation loop and eventually invokes mdlOutputs. Although well known in the field of real-time processing, it is noted that the term "context switch" refers to the process of storing and restoring the state (more specifically, the "execution context") of a thread so that execution can be resumed from the same point at a later time. This enables multiple processes to share a single processor (or processor core). Thus multiple threads may be executed concurrently on the processor.

At simulation time zero ($t_{Sim}=0$), initial values of output ports are written. Then the simulation engine ST is blocked and control is given to the task thread $TT_0$, which resumes execution in the mentioned endless loop (see Fig. 6, arrow c). As long as the task is not ready, control is passed between the simulation engine ST, which increases simulation time $t_{Sim}$ and this position in the task thread TTo (see Fig. 6, arrow d). Once the task is ready, execution resumes. In the present example, variable $t_{Code}$ is the sum of the execution time that has passed, $t_{Start}$ is the simulation time at which the current job got started. It follows the actual task function that may include the actual implementation of the desired control law. In the present example, the code of the task function is part of the task-thread wrapper in order to simplify the illustration in Fig. 6.

The task thread $TT_0$ executes the time-annotat-

ed task function instruction by instruction until a synchronization instruction is executed that calls the sync function *sync(·).* Upon each such sync function call, the task thread $TT_0$ either resumes execution or blocks and the simulation engine resumes (see Fig. 6, arrow e). The parameter of the sync function call (e.g., $t_0$) refers to the execution time of the code segment between the last reached synchronization instructions (or since the start of the task function, in case of the first occurrence of the synchronization instruction) up to the position of the current synchronization instruction. Only when the simulation time has drawn level with the execution time of the code ($t_{Sim} \geq t_0$), the task increments the variable $t_{Code}$ and resumes further with the next instruction of the task function (see Fig. 6, arrow f). It is noted that the conditions for a context switch may be checked on both sides (in the simulation thread ST or the task thread TTo) in order to avoid unnecessary switching overhead. In Simulink, inputs and outputs are accessed with standard API calls such as *ssGetInputPortSignalPtrs* and *ssGetOutputPortSignal* (see *http://mathworks.com/help/simulink/*).

Most of the time, the execution of the task function is ahead of the simulation of the plant that is represented by a "normal" (e.g. Simulink) block in the simulation model. At synchronization points (defined by the mentioned sync function), the execution of the task halts (by executing a context switch) and lets the plant catch up. The interval of synchronization points decides on the accuracy of the synchronization. While a divergence in the execution of the task function and the simulation of the plant has practically no effect between IO-operations, sync statements should immediately precede access to input or output ports (see also Fig. 6). As a consequence, the (simulated) time instant of communication with the environment as well as the subsequent inter-task communication can be exactly controlled (within the simulation). In order to ensure that a particular code segment is executed at the correct time, the context switch condition (i.e. has the simulation time reached the execution time defined in the code annotation) at synchronization points has to be checked at the expected times. The simulation engine therefore has to execute the xTask block (i.e. the *mdlUpdate* and *mdlOutputs* functions) at proper time instants. These times are determined by the Simulink solver, which supports two strategies: fixed-step and variable-step.

*Fixed-step approach* - For fixed-step solvers, the simulation engine increments the simulation time in each simulation step by a constant step size and the current simulation time of all blocks of the simulation model is an integer multiple of the constant step size. Since the execution times of code segments in the task function associated with an xTask block are given relative to the previous synchronization point (preceding the respective code segment) and since the execution path actually taken through the task function code is not known in advance, those execution times cannot be determined in advance. To avoid missing synchronization times, for a

task $\tau_i$ with period $\pi_i$, phase $\phi_i$, and the set of all execution times $\{t_0, t_1, \dots, t_n\}$ of the code segments in the respective task function, the offset of the respective block $b_i$ is defined to be 0.0s and the sample time (step size) to be $gcd\{\pi_i, \phi_i, t_0, t_1, \dots, t_n\}$ (gcd=greatest common divisor). The main drawback of this approach is the poor performance because of a small step size that is expected to be typically in the range of microseconds or below. It is noted that a constant sample time (step size) leads to an enormous amount of useless attempts to resume the task (e.g. by calling the *switchContext* function via the *mdlOutputs* function and immediately switching back, see arrows e and f in Fig, 6) if execution times are non-harmonic or vary in order of magnitude. Furthermore, analysis of the code is required to gather all execution times. As an additional restriction, execution times need to be static; they cannot be adapted during the simulation, for example, as a reaction to some global state change.

*Variable-step approach I* - With a variable-step solver, the step-size can vary from step to step. In a first approach, the common case is discussed, in which the period of a task is much greater than its overall execution time. In the fixed-step case, the execution of a (xTask) block is still triggered (by the simulation engine), even when the respective task has already finished execution. In contrast thereto, in the variable-step case, provides a benefit for tasks with a small duty cycle, i.e. for tasks that have a short execution time as compared to the task period (there is no need to call the respective block between the end time of the task execution and the time instant of the subsequent activation of the task). On the completion of a task job, the step size may be adjusted such that the next execution of the respective block, i.e., the next sample hit, occurs when the next job is to be dispatched, which may increase the performance of the simulation.

*Variable-step approach II* - Intuitively, a variable-step solver and Simulink's ability to set the time for the next execution of a specific block allows to only execute an xTask block when actually needed, i.e. once for each sync statement that is hit during code execution of the respective task function. The next sample hit (simulation time, at which the respective block is to be executed) is defined by the execution times encoded in the parameters of the *sync(·)* function call. However, Simulink's way of operation does not allow a straight-forward implementation. The API function to set the next sample hit (i.e., *ssSetTNext)* is only allowed to be called in the callback function *mdlGetTimeOfNextVarHit(·)* (see Fig. 1 and example of Fig. 6) while access to output ports, for example, is only allowed during the callback function *mdlOutputs(·).* According to Fig.1, the *mdlGetTimeOfNextVarHit(·)* function to set the next sample hit is called first in the simulation loop. However, no next execution times are known at this point. To overcome this problem, an intermediate step is inserted, which may be executed after every sync statement (*sync(·)* function call). A conservative execution time parameter for the intermediate step is a constant value in the order of the machine epsilon. The implementation of this approach is also illustrated in Figure 6 (example code for the *mdlGetTimeOf-NextVarHit(·)* function). In the worst case, this approach requires twice as much invocations of the xTask block (i.e. of the associated callback functions, see Fig. 1) as theoretically needed. More elaborate approaches might try to schedule those inevitable intermediate steps at time instants that match the actual execution times. While this may reduce the number of sample hits, it requires program analysis to identify the set of reachable sync statements at each time step and to choose the smallest value among them as the new step size. The leaner the control flow graph and the fewer diverging execution times, the higher is the potential for optimization. Alternatively, branch prediction techniques may be applied, provided that a mechanism to turn back simulation time and resume at an earlier point in time exists in case of a misprediction that leads to an overleaping of a synchronization point.

In the DF approach, there is no limitation with regard to the order of accessing input and output ports and the time that passes in between those accesses. For example, it is allowed to alternate input and output access without time being consumed in between.

In the mechanism described above it is assumed that a task block has direct feedthrough (DF). This allowed both reading inputs and writing outputs in a single function (e.g. the *mdlOutputs* function when using Simulink), which results in a straight forward synchronization between simulation engine ST and task thread $TT_i$ associated with task $\tau_i$. Additionally, there are no restrictions with regard to the sequence of access to input and output signal values. Basically, the same approach works also for systems with multiple xTask blocks $b_i$ and associated tasks $\tau_i$. However, some restrictions may apply to these cases, which are discussed in the following. In particular, a more elaborate synchronization mechanism may be needed for NDF blocks.

As mentioned above, one issue with DF blocks are circular dependencies (algebraic loops). Simulink and other simulation tools do not allow DF blocks to be connected in a loop and would report an algebraic loop error if the block diagram includes DF blocks connected in a loop. Connections between blocks represent the data-flow between the blocks, thus data dependencies between the respective tasks has to form a directed acyclic graph (DAG). For some block $b_0$ and some DF block $b_1$, the data-flow relation $b_0 \rightarrow b_1$ implies that $b_0 < b_1$ (block $b_0$ has to be executed before DF block $b_1$). This follows immediately from the Simulink rules for deriving the block update order. Consequently, for two tasks $\tau_0$ and $\tau_1$ implemented with direct feedthrough blocks $b_0$ and $b_1$, no bidirectional data-dependency $\tau_0 \leftrightarrow \tau_0$ is allowed. Although delay blocks, such as a Unit Delay Block (included in Simulink's standard block set), included in a loop would break an "illegal" algebraic loop, they would distort the timing behavior and cannot be used.

Furthermore, the handling of task dependencies may become more inflexible when implementing xTask blocks as DF blocks. A data dependency $\tau_0 \rightarrow \tau_1$ between tasks $\tau_0$ and $\tau_1$ is likely (but not necessarily) to result in a precedence constraint in the system specification. Such a precedence constraint can be enforced statically by the choice of task offsets and task periods or by task priorities. In simulation tools like Simulink, a data dependency between DF blocks influences the sorted order of blocks as explained above. Blocks that provide values have to appear in the block sorted order before blocks that use data values provided by the DF blocks. This order decides on the precedence of blocks and thus on the precedence of tasks. The position of a task block in the sorted order determines the priority of the respective task. Therefore it is not possible, in general, to decouple data dependencies from precedence relations and, more important, from priorities. It is noted that task precedence is unidirectional, while data-dependencies may result in a bidirectional relation $\tau_0 \leftrightarrow \tau_1$.

The issues discussed above obviate the need for using DF blocks for implementing the task set in many real-world scenarios. Therefore, a synchronization mechanism implemented with NDF blocks is proposed as an alternative. In Simulink blocks without DF ports (inputs/outputs) appear at the beginning of the block sorted order list in no particular order and there are no restrictions regarding cyclic dependencies. As Simulink implies no particular order of NDF blocks, a priority parameter may be used to set the order of specific blocks.

*Synchronizing NDF Blocks* - Below, the usage of NDF blocks for implementing tasks $\tau_i$ is described. Since no "illegal" cyclic dependencies (algebraic loops) between blocks $b_i$ can occur when using NDF blocks, there are no restrictions concerning the connections between the blocks and, consequently, on the data-dependencies between the individual tasks in the system. However, NDF blocks require a synchronization strategy that is somewhat different from the strategy described above for DF blocks. When using Simulink (or other simulation tools which operate in a similar manner), some restrictions may have to be considered. For example, in an NDF block, input values are accessible only in the S-function callback function *mdlUpdate*, while changes to outputs are propagated only in the callback function *mdlOutputs*. This limitation is herein referred to as function separation requirement.

This function separation requirement stands in contrast with the task function as a single course of action with access to input and output variables in an arbitrary order. To overcome this conflict, a synchronization mechanism between the simulation engine ST and a task thread $TT_i$ (associated with task $\tau_i$ of NDF block $b_i$) is proposed and presented below with reference to the listing depicted in Fig. 7. The differences to the example of Fig. 6 are indicated by the dashed rectangles used to highlight some code segments. In the present example, the callback function *mdlUpdate* is used by the simulation thread to call the task function of task $\tau_i$ instead of the

callback function *mdlOutput*. Further, a variable named "scope" is introduced to distinguish if the simulation thread ST has invoked the output function *mdlOutputs* or the update function *mdlUpdate* of the blocks. After setting the scope variable, the context is switched to the task thread $TT_i$ and waits in both cases. That is, the scope variable is indicative of the callback function that triggers the context switch. The *switchContext(·)* function may be the same as in the previous example of Fig. 6 as well as the wrapper function of the task thread and the *sync(·)* function, which decides when to switch back to the simulation thread ST and when to proceed with the execution of the task thread $TT_i$. However, in the present example, the *sync(·)* function is no longer called directly from the task function, but rather used by functions *syncRead(·)* and *syncWrite(·)* that are executed before accessing input values or writing output values, respectively. These functions ensure the correct timing according to the time parameters (times $t_0$ and $t_1$ in the task function *taskfunction(·)* used in the present example) by calling the *sync(·)* function and also ensure that the function separation requirement is complied with. That is, the *syncRead(·)* function checks the variable *scope* and triggers a context switch if *scope* ≠ UPDATE. That is, the context switch triggers the resumption of the S-Function callback function (e.g. *mdlOutput*) unless the *syncRead(·)* function was called by the *mdlUpdate* function. Similarly, the *syncWrite(·)* function will trigger a runtime error unless it is called by the correct S-Function callback function, i.e. the *mdlOutputs* function. As has been outlined in Fig. 1, in every simulation step, the simulation engine first executes the output function *mdlOutputs* and second it executes the update function *mdlUpdate* of each block. Therefore, for a read operation, once the simulation time has caught up with the desired execution time (as provided by the *sync(·)* function) such that the variable *tCode* is incremented and the *sync(·)* function returns, the context is switched back to the simulation engine ST until the *scope* variable indicates the UPDATE context (the while loop in *syncRead*). Similarly, the *scope* variable must be set to indicate the OUTPUT context in order to avoid a runtime error. In essence, an output operation should not occur after an input operation at the same simulation time instant. This needs to be ensured by the execution time instrumentation (i.e. the synchronization instructions *syrc(·)*). As an alternative to a runtime error, other strategies can be pursued (for example, a small timing deviation can be introduced).

The execution of the tasks $\tau_i$ (represented by the corresponding task threads $TT_i$) associated with the blocks $b_i$ may continue for several simulation steps. A task thread $TT_i$ executes for a certain amount of time (as defined by the timing annotation of the task code). The approach presented herein allows different strategies for the execution of all blocks $b_i$. In a first strategy, all tasks execute independently from each other (i.e., the execution of the tasks consumes simulation time but the tasks do not preempt each other, nor does the execution of one task postpone the start of another active task). Consequently, multiple tasks may execute (and make progress) in the same simulation step (at the same time). This strategy comes closest to "normal" Simulink simulations. Alternatively, a task-to-processor- (or task-to-core-) mapping may be defined, such that tasks, which are mapped to the same processor (core), compete for it. Thus, the execution of a task consumes processing time of the respective processor (core) *p*. That is, during execution of task $\tau_i$ mapped to processor *p* no other task $\tau_j$, which is mapped to the same processor *p*, is able to execute its task function (i ≠ j). This corresponds to (e.g. preemptively) scheduling a set of tasks on a given number of processors (e.g. included in embedded real-time target platform). Note that the mapping from tasks to processor(s) is part of the simulation model and is independent of the actual mapping of task threads to the processors or cores on the personal computer or workstation that runs the simulation.

Below the scheduling of task $\tau_i$ and a respective task state model are described. Exemplarily, it is assumed that all tasks are mapped to the same processor and a preemptive static-priority scheduling is used. While all activation times $t_i^a(k)$ of a task $\tau_i$ can be statically scheduled and are thus a-priori known, the corresponding start times $t_i^s(k)$ are not. This is because the termination times of tasks with higher priority, which delay the start of task $\tau_i$, are unknown in advance (at the time the static schedule is compiled). Those termination times are influenced by the execution path taken through their task function code. In addition to the aforementioned offset and period, a priority property may be assigned to every task (and also to its xTask block). In the examples described herein, only static-priority scheduling is considered. However, this is only one illustrative example and is not necessarily the case in other implementations, in which dynamic scheduling may be used.

Let $T = \{\tau_0, ..., \tau_n\}$ be the list of all tasks $\tau_i$ in a target system (represented by blocks $b_0, ..., b_n$ of a block diagram), ordered by their unique priority i with $\tau_0$ being the task with the highest priority. Every task is characterized by a period $\pi_i$ and an offset (phase) $\phi_i$. A simulation model (represented by the block diagram) is considered that contains, for each task $\tau_i$, a corresponding xTask block $b_i$ with a variable sampletime and a time-annotated version of the task function (by code instrumentation, e.g. by inserting the mentioned *sync(·)* or *syncRead(·)* and *syncWrite(·)instructions*). Additionally, each xTask block has parameters for the priority, the period and the offset of its associated task. As outlined above, tasks without internal synchronization point (apart from the synchronization mechanism using *sync(·)* instructions as described herein) are considered in the present description. Thus, there is no need for a "wait" state and a task state model for xTask blocks needs only to differentiate the states "ready", "running" and "suspended" (cf. OSEK Basic Task State Model).

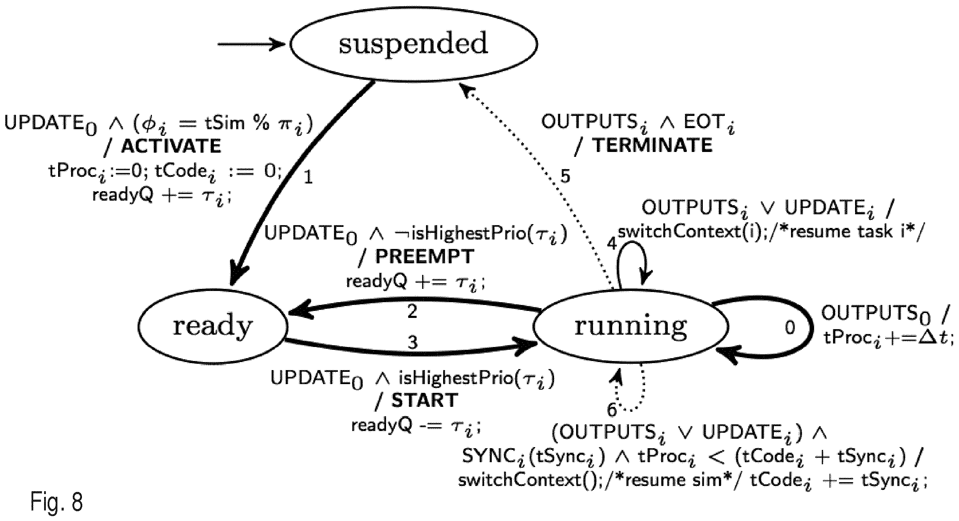

Fig. 8 visualizes the task state model used in the examples described herein and shows the model of the finite state machine (FSM) which may be used to implement the scheduler. The FSM may be defined as follows:

- States: {ready, running, suspended},
- Inputs: $\{t_{Sim}, \text{OUTPUTo}, ..., \text{OUTPUT}_n, \text{UPDATE}_0, ..., \text{UPDATE}_n, \text{SYNC}_i, \text{EOT}_i\}$,
- Actions: {ACTIVATE, START, PREEMPT, TERMINATE),
- Variables: $\{tProc_i, tCode_i, tSync_i, readyQ\}$.

The transitions between the states result in actions to ACTIVATE, START, PREEMPT, or TERMINATE a task $\tau_i$ and are used by many known schedulers. However, in the embodiments described herein state transitions are allowed only at few well-defined points that are aligned with the simulation thread ST (simulation engine, e.g. Simulink engine). In addition to the current simulation time $t_{Sim}$, the input signals $\text{OUTPUT}_i$ and $\text{UPDATE}_i$ (i=0, ..., n) are used to coordinate the task transitions with the simulation thread ST. Therefore, the (boolean) signals $\text{OUTPUT}_i$ and $\text{UPDATE}_i$ are enabled/disabled (e.g. set to 1 or 0) when the simulation thread ST enters/leaves the callback functions *mdlOutputs* and, respectively, *mdlUpdate* of block $b_i$. These input signals $\text{OUTPUT}_i$ and $\text{UPDATE}_i$ correspond to the *scope* variable mentioned above with reference to the code example of Fig. 7 and reference is made to the respective description above.

The blocks need to execute at particular time instants. Without loss of generality, we assume that all blocks are executed at every simulation time step. All the output and update signals $\text{OUTPUT}_i$ and $\text{UPDATE}_i$ are mutually exclusive and appear in the order $\{\text{OUTPUT}_0, ..., \text{OUTPUT}_n, ..., \text{UPDATE}_0, ..., \text{UPDATE}_n\}$ in every simulation step. When an output/update signal $\text{OUTPUT}_i/\text{UPDATE}_i$ is enabled, the simulation thread ST is in the output/update scope (i.e. calls the *mdlOutputs/mdlUpdate* function).

Most scheduling activities of all tasks $\tau_i$ are performed at the beginning of the update phase during the execution of the *mdlUpdate* function of block $b_0$ (i.e. when signal $\text{UPDATE}_0$ is enabled), namely the actions ACTIVATE (Fig. 8, numeral 1), PREEMPT (Fig. 8, numeral 2), START (Fig. 8, numeral 3) and also transition 0 (Fig. 8, numeral 0) as illustrated in Fig. 8. Only the transition with the TERMINATE action (Fig. 8, numeral 5) and the self-loop transitions (Fig. 8, numerals 4 and 6) in the running state of task $\tau_i$ are performed in the scope of its own *mdlOutputs* or *mdlUpdate* callback function (when the respective signal $\text{OUTPUT}_i$ or $\text{UPDATE}_i$ is enabled). It is noted, however, that this is merely an implementation example and may be implemented in a different way dependent on the scheduling strategy used.

The number associated with an arrow in Fig. 8 not only helps to identify the respective transition, it also represents the priority of a transition. Every transition guard (transition condition) with a particular priority k is evaluated sequentially for every task $\tau_i$ before evaluating the *n* transitions with priority *k+1*. For example, the activation of every task (1) is decided before the currently running task is potentially preempted (2).

As a consequence of the OUTPUTo/UPDATEo signals (indicating the calling function as discussed above), the transitions 0/1, 2, 3 (represented in Fig. 8 with a solid line arrow) may be performed for all tasks only during the execution of the output/update function of block $b_0$. The transitions 4, 5, 6/4, 6 for task $\tau_i$ may be performed only in the outputs/update function of the corresponding block $b_i$. In Fig. 8, dashed-line arrows represent transitions that are not performed within the context of the simulation thread ST, but within the context of the task $\tau_i$.

For the sake of simplicity and clarity only the $\text{OUTPUTS}_i$ and $\text{UPDATE}_i$ signals are considered in the discussion below, thus neglecting the remaining portions of the guard conditions and the state of a task $\tau_i$. Referring to Fig. 8, the transitions of tasks $\tau_0$, $\tau_1$, $\tau_2$ may occur in the following sequence at a particular simulation time instance:

- $\text{OUTPUTS}_0$ (calling function is the *mdlOptputs* function of task $\tau_0$ associated with block $b_0$) - 0($\tau_0$), 0($\tau_1$), 0($\tau_2$), and 4($\tau_0$), 5($\tau_0$), 6($\tau_0$).

- $\text{UPDATE}_0$ (calling function is the *mdlUpdate* function of task $\tau_0$ associated with block $b_0$) - 1($\tau_0$), 1($\tau_1$), 1($\tau_2$), 2($\tau_1$), 2($\tau_2$), 3($\tau_0$), 3($\tau_1$), 3($\tau_2$), and 4($\tau_0$), 6($\tau_0$).

- $\text{OUTPUTS}_1$ (calling function is the *mdlOptputs* function of task $\tau_1$ associated with block $b_1$) - 4($\tau_1$), 5($\tau_1$), 6($\tau_1$).

- $\text{UPDATE}_1$ (calling function is the *mdlUpdate* function of task $\tau_1$ associated with block $b_1$) - 4($\tau_1$), 6($\tau_1$).

- $\text{OUTPUTS}_2$ (calling function is the *mdlOptputs* function of task $\tau_2$ associated with block $b_2$) - 4($\tau_2$), 5($\tau_2$), 6($\tau_2$).

- $\text{UPDATE}_2$ (calling function is the *mdlUpdate* function of task $\tau_2$ associated with block $b_2$) - 4($\tau_2$), 6($\tau_2$).

- ...

The output scope (indicated by the $\text{OUTPUTS}_i$ signal) is only relevant for the task thread $\text{TT}_i$ (associated with $\tau_i$) that is in the state "running" (if there is a running task). First (transition 0), the variable $tProc_i$ is increased by the step size $\Delta t$, to indicate that the task $\tau_i$ had the processor since the last simulation step. Next (transition 4), the simulation engine ST is blocked when the output function *mdlOutput* is called (scope/signal OUTPUTS$_i$) by performing a context switch (to the task thread TT$_i$) and resume with the execution of the task thread TT$_i$. The task thread is executed (see also Fig. 7) until a synchronization instruction is reached (indicated by a *sync(·)* function call (with synchronization time parameter $t_{Sync}$). The synchronization mechanism as described above ensures that the task execution does not run to completion but maintains synchronization with the simulation environment ST. It also ensures that task output values are only written during the outputs scope (i.e., within the *mdlOutputs* callback function). On every synchronization point (*sync(·)* function call), the times, which the task was allowed to have the processor, are compared with the instrumented execution times in the code (summed up in variable $t_{Code}$, see also Fig. 7). Transition 6 indicates that eventually the execution of the task thread TT$_i$ is blocked and the context is switched back to the simulation engine ST. Upon a potential completion of the task function of task $\tau_i$ (e.g., indicated by the end-of-task input event EOT), the task thread TT$_i$ is terminated and set to suspended state (transition 5).

When entering the update scope (*mdlUpdate* function call with signal UPDATE$_0$ set), it is firstly decided (transition 1) whether to activate the suspended tasks. The suspended state is the initial state for every task. When the offset $\phi_i$ and period $\pi_i$ properties match with the current simulation time $t_{Sim}$, then the task $\tau_i$ (i.e. its task thread TT$_i$) is added to the queue of ready tasks (see Fig. 8, *readyQ*) and its state is set to READY. Subsequently, it is checked whether to preempt the running task (transition 2). The currently running task will be preempted if the ready queue *readyQ* includes a task with a higher priority than the running task. In this case, the running task is preempted, marked as READY, and added to the ready queue *readyQ*. Next (transition 3), if such a higher priority task was found, it is removed from the ready queue *readyQ* and its state is marked RUNNING. Then the running task may continue during the subsequent update scope with the execution of its task function by switching the context to the task thread TT$_i$ (transition 4) until the synchronization mechanism decides to block it and give control back to the simulation engine ST (transition 6).

As mentioned above, the simulation environment such as MATLAB/Simulink may be executed on any personal computer or workstation. Current releases of MATLAB/Simulink (e.g. R2016b) support various operating systems and configurations of the personal computer or workstation. The callback methods (e.g. *mdlInitialize-Sizes, mdlOutputs, mdlUpdate, mdlTerminate)* of MATLAB S-Functions may be implemented using, for example, the C/C++ programming language. MATLAB/Simulink also supports FORTRAN S-Functions. Although MATLAB/Simulink, which is regarded as a de-facto industry standard, is used in the present description, other simulation tools may provide a similar functionality. For example the Scilab/XCos simulation tool also allows to define user-specific blocks in a block-diagram and provide an interface to include user/application specific C/C++ libraries. Other block-oriented simulation tools may provide similar functionality.

Although the invention has been illustrated and described with respect to one or more implementations, alterations and/or modifications may be made to the illustrated examples without departing from the scope of the appended claims. In particular regard to the various functions performed by the above described components or structures (units, assemblies, devices, circuits, systems, tasks, threads, simulation engine, etc.), the terms (including a reference to a "means") used to describe such components are intended to correspond - unless otherwise indicated - to any component or structure, which performs the specified function of the described component (e.g., that is functionally equivalent), even though not structurally equivalent to the disclosed structure, which performs the function in the herein illustrated exemplary implementations of the invention.

## Claims

1. A method for simulation of a real-time system on a workstation; the realtime system comprising target hardware and at least one task ($\tau_i$) executed by the target hardware; the method comprises:

using a block-oriented simulation system for simulating a model of the realtime system; wherein the model is represented by a block diagram composed of at least one block ($b_i$) that represents the at least one task ($\tau_i$), wherein, for the purpose of simulation, each task ($\tau_i$) is implemented by a task function composed of a sequence of one or more code segments, wherein an execution time concerning execution by the target hardware is associated with each code segment, and wherein the simulation system includes a simulation engine (ST) that controls the execution of each task ($\tau_i$); wherein each task function is executed in a separate task thread (TT$_i$), and when the execution of the task function reaches the end of a code segment, a current simulation time provided by the simulation engine is compared with a desired execution time and execution of the task thread (TT$_i$) is suspended, when the current simulation time has not reached the desired execution time; the desired execution time being determined based on the execution times associated with the one or more code segments; and wherein the simulation engine (ST) performs a plurality of simulation steps, in which the simulation engine (ST) executes, for each block ($b_i$), at least a first callback function and a second callback function,

wherein the first callback function is configured to trigger a context switch to start execution of the respective task thread ($TT_i$), wherein the second callback function is configured to trigger the context switch to resume execution of the respective task thread ($TT_i$), and

wherein, before triggering the context switch, the first and the second callback function are configured to set a variable indicative of the specific callback function that triggers the context switch, wherein the variable is used to distinguish whether the simulation engine (ST) has invoked the first callback function or the second callback function.

2. The method of claim 1, wherein each task function is executed in a separate task thread within the same process as the simulation engine.

3. The method of claim 1 or 2,

wherein the execution times associated with the one or more code segments are defined in a synchronization function (*sync(), syncRead(·), syncWrite(·)*) called at the end of the one or more code segments,

and, to suspend the execution of the task thread ($TT_i$) a context switch to the simulation engine (ST) is performed when the current simulation time has not reached the desired execution time.

4. The method of claim 3,

wherein the task function includes read and write operations for reading input signal value(s) and, respectively, writing output signal value(s) of input and output signals of the respective block ($b_i$),

wherein the one or more code segments are determined by the read and write operations, so that each one of the read and write operations are preceded by one synchronization function (*sync(), syncRead(·), syncWrite(·)*).

5. The method of claim 4, wherein the synchronization instructions preceding read and write operations are configured to block further execution of the task thread ($TT_i$) dependent on the value of a variable, which is indicative of a callback function which is called by the simulation engine and directly or indirectly triggers the context switch.

6. The method of any of claims 1 to 5,

wherein the block diagram is composed of at least two blocks ($b_i$, $b_j$) that represents two respective tasks ($\tau_i$, $\tau_j$) implemented by task func-

tions which are concurrently executed in separate task threads ($TT_i$, $TT_j$), and

wherein a priority is assigned to each tasks ($\tau_i$, $\tau_j$).

7. The method of claim 6, wherein the task ($\tau_i$) with lower priority can only be preempted at the end of a code segment of the respective task function.

8. The method of any of claims 1 to 7, further comprising, when the end of a code segment is reached: continuing execution of the respective task function if the current simulation time has reached the desired execution time at the end of the code segment.

9. The method of any of claims 1 to 8, further comprising:
evaluating, for each task ($\tau_i$) and by the simulation engine (ST), guard conditions to decide whether to activate the task ($\tau_i$), to start the task ($\tau_i$) or to preempt the task ($\tau_i$).

10. The method of any of claims 9,

wherein the block diagram is composed of at least two blocks ($b_i$, $b_j$) that represents two respective tasks ($\tau_i$, $\tau_j$) implemented by task functions executed in separate task threads ($TT_i$, $TT_j$),

wherein the guard conditions are evaluated in a callback function associated with a first one of the at least two blocks ($b_i$, $b_j$).

11. The method of any of claims 1 to 9,

wherein the simulation engine (ST) performs a plurality of simulation steps, in which the simulation engine (ST) executes, for each block ($b_i$), one or more callback functions which are configured to trigger a context switch to start or resume execution of the respective task thread ($TT_i$), and

wherein the method further comprises evaluating, for each task ($\tau_i$) and by the callback function of a first block ($b_0$) of the blocks ($b_i$), guard conductions to decide whether to activate the task ($\tau_i$), to start the task ($\tau_i$) or to preempt the task ($\tau_i$).

12. The method of any of claims 1 to 11, wherein the block-oriented simulation system is provided by the MATLAB/Simulink simulation tool.

13. A system adapted to simulate a real-time system comprising target hardware and at least one task ($\tau_i$) executed by the target hardware; the system comprising:

a workstation including at least one processor executing an operating system and a block-oriented simulation system for simulating a model of the real-time system;

wherein the model is represented by a block diagram composed of at least one block ($b_i$) that represents at least one task ($\tau_i$), wherein, for the purpose of simulation, each task ($\tau_i$) is implemented by a task function composed of a sequence of one or more code segments, wherein an execution time concerning execution by the target hardware is associated with each code segment, and wherein the simulation system includes a simulation engine (ST) that controls the execution of the each task ($\tau_i$);

wherein each task function is implemented to be executed in a separate task thread ($TT_i$) and, when the execution of the task function reaches the end of a code segment, a current simulation time provided by the simulation engine is compared with a desired execution time and execution of the task thread ($TT_i$) is suspended, when the current simulation time has not reached the desired execution time; the desired execution time being determined based on the execution times associated with the one or more code segments; and

wherein the simulation engine (ST) is configured to perform a plurality of simulation steps, in which the simulation engine (ST) executes, for each block ($b_i$), at least a first callback function and a second callback function,

wherein the first callback function is configured to trigger a context switch to start execution of the respective task thread ($TT_i$), wherein the second callback function is configured to trigger the context switch to resume execution of the respective task thread ($TT_i$), and

wherein, before triggering the context switch, the first and the second callback function are configured to set a variable indicative of the specific callback function that triggers the context switch, wherein the variable is used to distinguish whether the simulation engine (ST) has invoked the first callback function or the second callback function.

14. The system of claim 13, wherein each task function is implemented to be executed in a separate task thread within the same process as the simulation engine.

15. The system of claim 13 or 14,

wherein the execution times associated with the one or more code segments are defined in a synchronization function (*sync(), syncRead(·), syncWrite(·)*) called at the end of the one or more code segments,

and, to suspend the execution of the task thread ($TT_i$), a context switch to the simulation engine (ST) is performed when the current simulation time has not reached the desired execution time.

**Patentansprüche**

1. Verfahren zur Simulation eines Echtzeitsystems auf einer Arbeitsstation; wobei das Echtzeitsystem Zielhardware und mindestens eine Aufgabe ($\tau_i$) umfasst, welche von der Zielhardware ausgeführt wird; wobei das Verfahren umfasst:

Verwendung eines blockorientierten Simulationssystems zum Simulieren eines Modells des Echtzeitsystems;

wobei das Modell durch ein Blockdiagramm repräsentiert ist, welches aus mindestens einem Block ($b_i$) besteht, welcher die mindestens eine Aufgabe ($\tau_i$) repräsentiert, wobei für den Zweck der Simulation jede Aufgabe ($\tau_i$) durch eine Aufgabenfunktion implementiert wird, welche aus einer Sequenz von einem oder mehreren Codesegmenten besteht, wobei jedem Codesegment eine Ausführungszeit bezüglich der Ausführung durch die Zielhardware zugeordnet ist, und wobei das Simulationssystem eine Simulationsmaschine (ST) beinhaltet, welche die Ausführung jeder Aufgabe ($\tau_i$) steuert;

wobei jede Aufgabenfunktion in einem separaten Aufgaben-Thread ($TT_i$) ausgeführt wird, und eine aktuelle Simulationszeit, welche von der Simulationsmaschine bereitgestellt wird, mit einer gewünschten Ausführungszeit verglichen wird und die Ausführung des Aufgaben-Threads ($TT_i$) unterbrochen wird, wenn die aktuelle Simulationszeit nicht die gewünschte Ausführungszeit aufweist, wenn die Ausführung der Aufgabenfunktion das Ende eines Codesegments erreicht; wobei die gewünschte Ausführungszeit basierend auf den Ausführungszeiten bestimmt wird, welche dem einen oder den mehreren Codesegmenten zugeordnet sind; und

wobei die Simulationsmaschine (ST) eine Vielzahl von Simulationsschritten ausführt, in welchen die Simulationsmaschine (ST) für jeden Block ($b_i$) mindestens eine erste Rückruffunktion und eine zweite Rückruffunktion ausführt,

wobei die erste Rückruffunktion dazu konfiguriert ist, einen Kontextwechsel auszulösen, um die Ausführung des jeweiligen Aufgaben-Threads ($TT_i$) zu starten, wobei die zweite Rückruffunktion dazu konfiguriert ist, den Kontextwechsel auszulösen, um die Ausführung des jeweiligen Aufgaben-Threads ($TT_i$) wieder aufzunehmen, und

wobei die erste und die zweite Rückruffunktion vor dem Auslösen des Kontextwechsels dazu konfiguriert sind, eine Variable festzulegen, welche die spezifische Rückruffunktion angibt, welche den Kontextwechsel auslöst, wobei die Variable verwendet wird, um zu unterscheiden, ob die Simulationsmaschine (ST) die erste Rückruffunktion oder die zweite Rückruffunktion aufgerufen hat.

2. Verfahren nach Anspruch 1, wobei jede Aufgabenfunktion in einem separaten Aufgaben-Thread innerhalb des gleichen Prozesses wie die Simulationsmaschine ausgeführt wird.

3. Verfahren nach Anspruch 1 oder 2,

   wobei die Ausführungszeiten, welche dem einen oder den mehreren Codesegmenten zugeordnet sind, in einer Synchronisationsfunktion (*sync*(·), *syncRead*(·), *syncWrite*(·)) definiert sind, welche an dem Ende des einen oder der mehreren Codesegmente aufgerufen wird, und wobei ein Kontextwechsel zu der Simulationsmaschine (ST) durchgeführt wird, um die Ausführung des Aufgaben-Threads $(TT_i)$ zu unterbrechen, wenn die aktuelle Simulationszeit die gewünschte Ausführungszeit nicht erreicht hat.

4. Verfahren nach Anspruch 3, wobei die Aufgabenfunktion Leseund Schreiboperationen zum Lesen von Eingangssignalwert(en) bzw. zum Schreiben von Ausgangssignalwert(en) von Eingangs- und Ausgangssignalen des jeweiligen Blocks $(b_i)$ beinhaltet, wobei das eine oder die mehreren Codesegmente durch die Leseund Schreiboperationen bestimmt werden, so dass jeder der Leseund Schreiboperationen eine Synchronisationsfunktion (*sync*(·), *syncRead*(·), syncWrite(·)) vorausgeht.

5. Verfahren nach Anspruch 4, wobei die Synchronisationsanweisungen, welche den Lese- und Schreiboperationen vorausgehen, dazu konfiguriert sind, die weitere Ausführung des Aufgaben-Threads $(TT_i)$ in Abhängigkeit vom Wert einer Variablen zu blockieren, welche eine Rückruffunktion angibt, welche von der Simulationsmaschine aufgerufen wird und direkt oder indirekt den Kontextwechsel auslöst.

6. Verfahren nach einem der Ansprüche 1 bis 5,

   wobei das Blockdiagramm aus mindestens zwei Blöcken $(b_i, b_j)$ besteht, welche zwei jeweilige Aufgaben $(\tau_i, \tau_j)$ repräsentieren, welche durch Aufgabenfunktionen implementiert sind, welche gleichzeitig in separaten Aufgaben-Threads $(TT_i, TT_j)$ ausgeführt werden, und wobei jeder Aufgabe $(\tau_i, \tau_j)$ eine Priorität zugeordnet ist.

7. Verfahren nach Anspruch 6, wobei die Aufgabe $(\tau_i)$ mit niedrigerer Priorität nur am Ende eines Codesegments der jeweiligen Aufgabenfunktion vorgezogen werden kann.

8. Verfahren nach einem der Ansprüche 1 bis 7, ferner Folgendes umfassend, wenn das Ende eines Codesegments erreicht ist: Fortsetzen einer Ausführung der jeweiligen Aufgabenfunktion, wenn die aktuelle Simulationszeit die gewünschte Ausführungszeit am Ende des Codesegments erreicht hat.

9. Verfahren nach einem der Ansprüche 1 bis 8, ferner umfassend: Auswerten von Schutzbedingungen für jede Aufgabe $(\tau_i)$ und durch die Simulationsmaschine (ST), um zu entscheiden, ob die Aufgabe $(\tau_i)$ aktiviert, die Aufgabe $(\tau_i)$ gestartet oder die Aufgabe $(\tau_i)$ vorgezogen werden soll.

10. Verfahren nach einem der Ansprüche 9,

    wobei das Blockdiagramm aus mindestens zwei Blöcken $(b_i, b_j)$ besteht, welche zwei jeweilige Aufgaben $(\tau_i, \tau_j)$ repräsentieren, welche durch Aufgabefunktionen implementiert sind, welche in getrennten Aufgaben-Threads $(TT_i, TT_j)$ ausgeführt werden, wobei die Schutzbedingungen in einer Rückruffunktion ausgewertet werden, welche einem ersten der mindestens zwei Blöcke $(b_i, b_j)$ zugeordnet ist.

11. Verfahren nach einem der Ansprüche 1 bis 9,

    wobei die Simulationsmaschine (ST) eine Vielzahl von Simulationsschritten durchführt, in welchen die Simulationsmaschine (ST) für jeden Block $(b_i)$ eine oder mehrere Rückruffunktionen ausführt, welche dazu konfiguriert sind, einen Kontextwechsel auszulösen, um eine Ausführung des jeweiligen Aufgaben-Threads $(TT_i)$ zu starten oder wieder aufzunehmen, und wobei das Verfahren ferner ein Auswerten von Schutzleitungen für jede Aufgabe $(\tau_i)$ und durch die Rückruffunktion eines ersten Blocks $(b_0)$ der Blöcke $(b_i)$ umfasst, um zu entscheiden, ob die Aufgabe $(\tau_i)$ aktiviert, die Aufgabe $(\tau_i)$ gestartet oder die Aufgabe $(\tau_i)$ vorgezogen werden soll.

12. Verfahren nach einem der Ansprüche 1 bis 11, wobei das blockorientierte Simulationssystem durch das MATLAB/Simulink-Simulationswerkzeug bereitgestellt wird.

13. System, welches zur Simulation eines Echtzeitsystems ausgelegt ist und Zielhardware und mindestens eine Aufgabe ($\tau_i$)umfasst, welche von der Zielhardware ausgeführt wird; wobei das System Folgendes umfasst

eine Arbeitsstation, welche mindestens einen Prozessor beinhaltet, welcher ein Betriebssystem und ein blockorientiertes Simulationssystem zum Simulieren eines Modells des Echtzeitsystems ausführt;
wobei das Modell durch ein Blockdiagramm repräsentiert ist, welches aus mindestens einem Block ($b_i$) besteht, welcher mindestens eine Aufgabe ($\tau_i$) repräsentiert, wobei für den Zweck der Simulation jede Aufgabe ($\tau_i$) durch eine Aufgabenfunktion implementiert wird, welche aus einer Sequenz von einem oder mehreren Codesegmenten besteht, wobei jedem Codesegment eine Ausführungszeit bezüglich der Ausführung durch die Zielhardware zugeordnet ist, und wobei das Simulationssystem eine Simulationsmaschine (ST) beinhaltet, welche die Ausführung jeder Aufgabe ($\tau_i$) steuert;
wobei jede Aufgabenfunktion in einem separaten Aufgaben-Thread ($TT_i$) ausgeführt wird, und eine aktuelle Simulationszeit, welche von der Simulationsmaschine bereitgestellt wird, mit einer gewünschten Ausführungszeit verglichen wird und die Ausführung des Aufgaben-Threads ($TT_i$) unterbrochen wird, wenn die aktuelle Simulationszeit nicht die gewünschte Ausführungszeit aufweist, wenn die Ausführung der Aufgabenfunktion das Ende eines Codesegments erreicht; wobei die gewünschte Ausführungszeit basierend auf den Ausführungszeiten bestimmt wird, welche dem einen oder den mehreren Codesegmenten zugeordnet sind; und wobei die Simulationsmaschine (ST) dazu konfiguriert ist, eine Vielzahl von Simulationsschritten auszuführen, in welchen die Simulationsmaschine (ST) für jeden Block ($b_i$) mindestens eine erste Rückruffunktion und eine zweite Rückruffunktion ausführt, wobei die erste Rückruffunktion dazu konfiguriert ist, einen Kontextwechsel auszulösen, um die Ausführung des jeweiligen Aufgaben-Threads ($TT_i$) zu starten, wobei die zweite Rückruffunktion dazu konfiguriert ist, den Kontextwechsel auszulösen, um die Ausführung des jeweiligen Aufgaben-Threads ($TT_i$) wieder aufzunehmen, und wobei die erste und die zweite Rückruffunktion vor dem Auslösen des Kontextwechsels dazu konfiguriert sind, eine Variable festzulegen, welche die spezifische Rückruffunktion angibt, welche den Kontextwechsel auslöst, wobei die Variable verwendet wird, um zu unterscheiden, ob die Simulationsmaschine (ST) die erste Rückruffunktion oder die zweite Rückruffunktion aufgerufen hat.

14. System nach Anspruch 13, wobei jede Aufgabenfunktion dazu implementiert ist, in einem separaten Aufgaben-Thread innerhalb des gleichen Prozesses wie die Simulationsmaschine ausgeführt zu werden.

15. System nach Anspruch 13 oder 14,

wobei die Ausführungszeiten, welche dem einen oder den mehreren Codesegmenten zugeordnet sind, in einer Synchronisationsfunktion (*sync(·), syncRead(·), syncWrite(·)*) definiert sind, welche am Ende des einen oder der mehreren Codesegmente aufgerufen wird,
und wobei ein Kontextwechsel zur Simulationsmaschine (ST) durchgeführt wird, um die Ausführung des Aufgaben-Threads ($TT_i$) zu unterbrechen, wenn die aktuelle Simulationszeit die gewünschte Ausführungszeit nicht erreicht hat.

## Revendications

1. Procédé de simulation d'un système en temps réel sur un poste de travail ; le système en temps réel comprenant un matériel cible et au moins une tâche ($\tau_i$) exécutée par le matériel cible ; le procédé comprend :

l'utilisation d'un système de simulation organisé en blocs permettant de simuler un modèle du système en temps réel ;
dans lequel le modèle est représenté par un schéma synoptique composé d'au moins un bloc ($b_i$) qui représente l'au moins une tâche ($\tau_i$), dans lequel, à des fins de simulation, chaque tâche ($\tau_i$) est mise en œuvre par une fonction de tâche composée d'une séquence d'un ou de plusieurs segments de code, dans lequel un temps d'exécution concernant l'exécution par le matériel cible est associé à chaque segment de code, et dans lequel le système de simulation comprend un moteur de simulation (ST) qui commande l'exécution de chaque tâche ($\tau_i$) ;
dans lequel chaque fonction de tâche est exécutée dans un fil de tâche ($TT_i$) séparé et, lorsque l'exécution de la fonction de tâche atteint la fin d'un segment de code, un temps de simulation actuel fourni par le moteur de simulation est comparé à un temps d'exécution souhaité et l'exécution du fil de tâche ($TT_i$) est suspendue, lorsque le temps de simulation actuel n'a pas atteint le temps d'exécution souhaité ; le temps d'exécution souhaité étant déterminé en fonction des temps d'exécution associés aux un ou plusieurs segments de code ; et

dans lequel le moteur de simulation (ST) exécute une pluralité d'étapes de simulation, dans lesquelles le moteur de simulation (ST) exécute, pour chaque bloc ($b_i$), au moins une première fonction de rappel et une seconde fonction de rappel,

dans lequel la première fonction de rappel est configurée pour déclencher un changement de contexte afin de lancer l'exécution du fil de tâche ($TT_i$) respectif, dans lequel la seconde fonction de rappel est configurée pour déclencher le changement de contexte afin de reprendre l'exécution du fil de tâche ($TT_i$) respectif, et

dans lequel, avant le déclenchement du changement de contexte, la première et la seconde fonction de rappel sont configurées pour définir une variable indiquant la fonction de rappel spécifique qui déclenche le changement de contexte, dans lequel la variable est utilisée pour déterminer si le moteur de simulation (ST) a appelé le première fonction de rappel ou la seconde fonction de rappel.

2. Procédé selon la revendication 1, dans lequel chaque fonction de tâche est exécutée dans un fil de tâche séparé au sein du même processus que le moteur de simulation.

3. Procédé selon la revendication 1 ou 2,

dans lequel les temps d'exécution associés aux un ou plusieurs segments de code sont définis dans une fonction de synchronisation (*sync(·), syncRead(·), syncWrite(·)*) appelée à la fin des un ou plusieurs segments de code,

et, pour suspendre l'exécution du fil de tâche ($TT_i$), un changement de contexte du moteur de simulation (ST) est effectué lorsque le temps de simulation actuel n'a pas atteint le temps d'exécution souhaité.

4. Procédé selon la revendication 3,

dans lequel la fonction de tâche comporte des opérations de lecture et d'écriture pour lire la ou les valeurs de signal d'entrée et, respectivement, écrire la ou les valeurs de signal de sortie des signaux d'entrée et de sortie du bloc ($b_i$) respectif,

dans lequel les un ou plusieurs segments de code sont déterminés par les opérations de lecture et d'écriture, de sorte que chacune des opérations de lecture et d'écriture est précédée d'une fonction de synchronisation (*sync (·), syncRead(·), syncWrite(·)*).

5. Procédé selon la revendication 4,
dans lequel les instructions de synchronisation précédant les opérations de lecture et d'écriture sont configurées pour bloquer la poursuite de l'exécution du fil de tâche ($TT_i$) en fonction de la valeur d'une variable, qui indique une fonction de rappel qui est appelée par le moteur de simulation et déclenche directement ou indirectement le changement de contexte.

6. Procédé selon l'une quelconque des revendications 1 à 5,
dans lequel le schéma synoptique est composé d'au moins deux blocs ($b_i$, $b_j$) qui représentent deux tâches ($\tau_i$, $\tau_j$) respectives mises en œuvre par des fonctions de tâche qui sont exécutées simultanément dans des fils de tâche ($TT_i$, $TT_j$) séparés, et dans lequel une priorité est attribuée à chaque tâche ($\tau_i$, $\tau_j$).

7. Procédé selon la revendication 6,
dans lequel la tâche ($\tau_j$) ayant une priorité inférieure ne peut être préemptée qu'à la fin d'un segment de code de la fonction de tâche respective.

8. Procédé selon l'une quelconque des revendications 1 à 7, comprenant en outre, lorsque la fin d'un segment de code est atteinte :
la poursuite de l'exécution de la fonction de tâche respective si le temps de simulation actuel a atteint le temps d'exécution souhaité à la fin du segment de code.

9. Procédé selon l'une quelconque des revendications 1 à 8, comprenant en outre :
l'évaluation, pour chaque tâche ($\tau_i$) et par le moteur de simulation (ST), de conditions de garde pour décider d'activer la tâche ($\tau_i$), afin de lancer la tâche ($\tau_i$) ou de préempter la tâche ($\tau_i$).

10. Procédé selon la revendication 9,

dans lequel le schéma synoptique est composé d'au moins deux blocs ($b_i$, $b_j$) qui représentent deux tâches ($\tau_i$, $\tau_j$) respectives mises en œuvre par des fonctions de tâche exécutées dans des fils de tâche ($TT_i$, $TT_j$) séparés,

dans lequel les conditions de garde sont évaluées dans une fonction de rappel associée à un premier des au moins deux blocs *($b_i$, $b_j$)*.

11. Procédé selon l'une quelconque des revendications 1 à 9, dans lequel le moteur de simulation (ST) exécute une pluralité d'étapes de simulation, dans lesquelles le moteur de simulation (ST) exécute, pour chaque bloc ($b_i$), une ou plusieurs fonctions de rappel qui sont configurées pour déclencher un changement de contexte pour lancer ou reprendre l'exécution du fil de tâche (TT$_i$) respectif, et
dans lequel le procédé comprend en outre l'évaluation, pour chaque tâche ($\tau_i$) et par la fonction de rappel d'un premier bloc ($b_0$) parmi les blocs ($b_i$), de conditions de garde pour décider d'activer la tâche ($\tau_i$), de lancer la tâche ($\tau_i$) ou de préempter la tâche ($\tau_i$).

12. Procédé selon l'une quelconque des revendications 1 à 11, dans lequel le système de simulation organisé en blocs est fourni par l'outil de simulation de MATLAB/Simulink.

13. Système conçu pour simuler un système en temps réel comprenant un matériel cible et au moins une tâche ($\tau_i$) exécutée par le matériel cible ; le système comprenant :

un poste de travail comportant au moins un processeur exécutant un système d'exploitation et un système de simulation organisé en blocs pour simuler un modèle du système en temps réel ;
dans lequel le modèle est représenté par un schéma synoptique composé d'au moins un bloc ($b_i$) qui représente au moins une tâche ($\tau_i$), dans lequel, à des fins de simulation, chaque tâche ($\tau_i$) est mise en œuvre par une fonction de tâche composée d'une séquence d'un ou de plusieurs segments de code, dans lequel un temps d'exécution concernant l'exécution par le matériel cible est associé à chaque segment de code, et dans lequel le système de simulation comprend un moteur de simulation (ST) qui commande l'exécution de chaque tâche ($\tau_i$) ;
dans lequel chaque fonction de tâche est mise en œuvre pour être exécutée dans un fil de tâche (TT$_i$) séparé et, lorsque l'exécution de la fonction de tâche atteint la fin d'un segment de code, un temps de simulation actuel fourni par le moteur de simulation est comparé à un temps d'exécution souhaité et l'exécution du fil de tâche (TT$_i$) est suspendue, lorsque le temps de simulation actuel n'a pas atteint le temps d'exécution souhaité ; le temps d'exécution souhaité étant déterminé en fonction des temps d'exécution associés aux un ou plusieurs segments de code ; et
dans lequel le moteur de simulation (ST) est configuré pour exécuter une pluralité d'étapes de simulation, dans lesquelles le moteur de simulation (ST) exécute, pour chaque bloc ($b_i$), au moins une première fonction de rappel et une seconde fonction de rappel,
dans lequel la première fonction de rappel est configurée pour déclencher un changement de contexte afin de lancer l'exécution du fil de tâche (TT$_i$) respectif, dans lequel la seconde fonction de rappel est configurée pour déclencher le changement de contexte afin de reprendre l'exécution du fil de tâche (TT$_i$) respectif, et
dans lequel, avant le déclenchement du changement de contexte, la première et la seconde fonction de rappel sont configurées pour définir une variable indiquant la fonction de rappel spécifique qui déclenche le changement de contexte, dans lequel la variable est utilisée pour déterminer si le moteur de simulation (ST) a appelé le première fonction de rappel ou la seconde fonction de rappel.

14. Procédé selon la revendication 13, dans lequel chaque fonction de tâche est mise en œuvre pour être exécutée dans un fil de tâche séparé au sein du même processus que le moteur de simulation.

15. Système selon la revendication 13 ou 14,

dans lequel les temps d'exécution associés aux un ou plusieurs segments de code sont définis dans une fonction de synchronisation (*sync(·), syncRead(·), syncWrite(·)*) appelée à la fin des un ou plusieurs segments de code,
et, pour suspendre l'exécution du fil de tâche (TT$_i$), un changement de contexte du moteur de simulation (ST) est effectué lorsque le temps de simulation actuel n'a pas atteint le temps d'exécution souhaité.

Fig. 1

Fig. 2

Fig. 3

ST

Simulation Task
(Simulink® Engine)

call ① | return | call ② | return | | call ① | return | call ② | return

mdlOutputs(·) | mdlUpdate(·) | · · · · · | mdlOutputs(·) | mdlUpdate(·)

resume | suspend | resume | suspend | | resume | suspend | resume | suspend

Task $\tau_0$ | TT$_0$ | | Task $\tau_i$ | TT$_i$

xTask block $b_0$ | | xTask block $b_i$

## Fig. 4

Task $\tau_i$

code segment CS0

delay statement (execution time of CS0)

code segment CS1

delay statement (execution time of CS1)

code segment CS2

delay statement (execution time of CS2)

:

## Fig. 5

**Fig. 6**

**Fig. 7**

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2275931 A1
- US 6952825 B1

- US 20020166110 A1

**Non-patent literature cited in the description**

- Theory of Modeling and Simulation: Integrating Discrete Event and Continuous Complex Dynamic System. **ZEIGLER.** Elsevier Science Publishing. January 2000

- The Embedded Machine: Predictable, Portable Real Time Code. **HENZINGER, KIRSCH.** Proc. of the International Conference on Programming Language Design and Implementation (PLDI). ACM Press, 2002, 315-3267